# EUROPEAN PATENT APPLICATION

(11) **EP 4 614 731 A1**
(43) Date of publication of application: **10.09.2025**
(21) Application number: 25155238.6
(22) Date of filing: 31.01.2025
(51) Int. Cl.: H01R 4/30, F16B 23/00, H02B 1/56, H05K 7/20, H02G 5/10, F16B 5/02, F16B 35/06, H01R 4/62

(54) **FASTENERS AND ELECTRICAL ASSEMBLIES**

(30) Priority: 07.03.2024 US 202418598458
(71) Applicant: Schneider Electric USA, Inc., Andover, MA 01810 (US)
(72) Inventor: FABER, Timothy Robert, 01810 Andover, MA (US); WOODSON, Cameron Lee, 01810 Andover, MA (US)
(74) Representative: Manitz Finsterwald Patent- und Rechtsanwaltspartnerschaft mbB

(57) **Abstract**

In accordance with at least one aspect of this disclosure, a fastener can include a shaft comprising a first material. The fastener can include a head attached to the shaft comprising a second material, wherein the second material is more electrically conductive and/or thermally conductive than the first material.

## Description

### FIELD

This disclosure relates to fasteners, e.g., for electrical assemblies.

### BACKGROUND

Certain electrical assemblies include fasteners that must handle large currents and be sufficiently thermally conductive while also being physically strong. Traditional fasteners have limits in current and thermal load due to dimensional limitations and material limitations in order to maintain strength.

Such conventional methods and systems have generally been considered satisfactory for their intended purpose. However, there is still a need in the art for improvements. This disclosure provides a solution for this need.

### SUMMARY

In accordance with at least one aspect of this disclosure, a fastener can include a shaft comprising a first material. The fastener can include a head attached to the shaft comprising a second material, wherein the second material is more electrically conductive and/or thermally conductive than the first material.

In certain embodiments, the head extends radially outward of the shaft. In certain embodiments, the shaft includes first threads for threading into one or more receiver openings having mating threads.

In certain embodiments, the head includes reverse head threads configured to mate with reverse shaft threads to allow the head to be reverse threaded to the shaft relative to the first threads. In certain embodiments, the head includes an inner opening defined therethrough having the reverse head threads. The head can be configured to receive the reverse shaft threads in the inner opening. In certain embodiments, a top surface of the shaft is accessible from a top of the fastener. The top surface of the shaft can include a tool interface defined therein.

In certain embodiments, the head can include a trough defined in a top surface thereof configured to receive a conductive spring element. The trough can be annular and configured to receive an annular conductive spring element. In certain embodiments, the fastener can include the conductive spring element (e.g., a steel annular spring configured to seat into the trough and to be compressed in an axial direction of the shaft).

In certain embodiments, the first material is steel and the second material is copper or brass. Any other suitable first material and second material such that the second material has higher electrical and/or thermal conductivity is contemplated herein.

In accordance with at least one aspect of this disclosure, an electrical assembly can include a plurality of electrically conductive layers, a fastener holding the plurality of electrically conductive layers (e.g., any suitable embodiment of a fastener as disclosed herein), and a thermal interface module in thermal communication with the head for drawing heat away from the fastener. Any suitable total number of fasteners (e.g., one or more, for example, four) for the assembly is contemplated herein.

In certain embodiments, the plurality of electrically conductive layers can include a first lug configured to connect to one or more first cables, a second lug configured to connect to one or more second cables, and a circuit breaker terminal sandwiched between the first lug and the second lug. In certain embodiments, the fastener cab be threaded to a receiver opening (e.g., a nut) to compress the plurality of electrically conductive layers.

The thermal interface module can include a terminal interface layer (e.g., made of silver coated copper) disposed on the first lug and comprising an opening configured to receive the head of the fastener (e.g., to surround the head of the fastener). The assembly can include a conductive spring element (e.g., as disclosed herein) disposed in a trough of the head (e.g., as disclosed herein). The conductive spring element can be configured to extend beyond a top surface of the terminal interface layer, for example (e.g., and a top surface of the head does not extend to or beyond the top surface of the terminal interface layer).

In certain embodiments, the thermal interface module can include a cap layer disposed over the head of the fastener to be in electrical communication with the spring element extending from the head (e.g., and/or to compress the conductive spring element, e.g., when fastened to the terminal interface layer and/or the first lug). In certain embodiments, the thermal interface module further includes an electrically isolated, thermally conducting heat sink configured to receive heat from the fastener and conduct heat to an atmosphere.

These and other features of the embodiments of the subject disclosure will become more readily apparent to those skilled in the art from the following detailed description taken in conjunction with the drawings.

### BRIEF DESCRIPTION OF THE DRAWINGS

So that those skilled in the art to which the subject disclosure appertains will readily understand how to make and use the devices and methods of the subject disclosure without undue experimentation, embodiments thereof will be described in detail herein below with reference to certain figures, wherein:
Fig. 1A is a perspective view of an embodiment of a fastener in accordance with this disclosure.
Fig. 1B is a perspective view of an embodiment of a conductive spring element in accordance with this disclosure.
Fig. 1C is a perspective view of the embodiment of Fig. 1A, shown without the conductive spring element.
Fig. 1D is a perspective cross-sectional view of the embodiment of Fig. 1C.
Fig. 1E is a partial cross-sectional view the embodiment of Fig. 1C shown disposed in an embodiment of an electrical assembly.
Fig. 1F is a close-up view of the embodiment of Fig. 1E, showing a head of the fastener.
Fig. 2A is a perspective view of an embodiment of an electrical assembly in accordance with this disclosure.
Fig. 2B is a cross-sectional view of the embodiment of Fig. 2A, shown having a plurality of the fastener of Fig. 1A.
Fig. 2C is a close-up view of the embodiment of Fig. 2B.
Fig. 2D is a perspective view of a portion of the embodiment of Fig 2A.
Fig. 2E is an exploded view of the portion shown in Fig. 2D.
Fig. 3A is an exploded view of a portion of the embodiment of an assembly of Fig. 2A.
Fig. 3B is another exploded view of the portion of Fig. 3A, shown without a first lug and second lug.
Fig. 3C is a partially assembled view of the portion of Fig. 3B.
Fig. 4A illustrates an exploded view of a portion of the assembly of Fig. 2A.
Fig. 4B illustrates an assembled view of the portion of Fig. 4A.
Fig. 4C illustrates an assembled view of the portion of Fig. 4B, showing an assembled thermal interface module.
Fig. 4D illustrates an assembled view of the portion of Fig. 4B, shown installed in the assembly of Fig. 2A without a completed thermal interface module.

### DETAILED DESCRIPTION

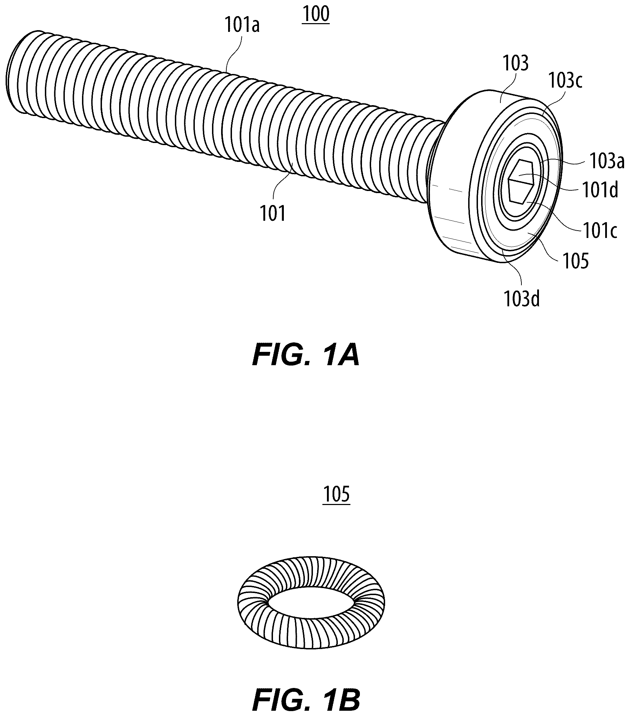

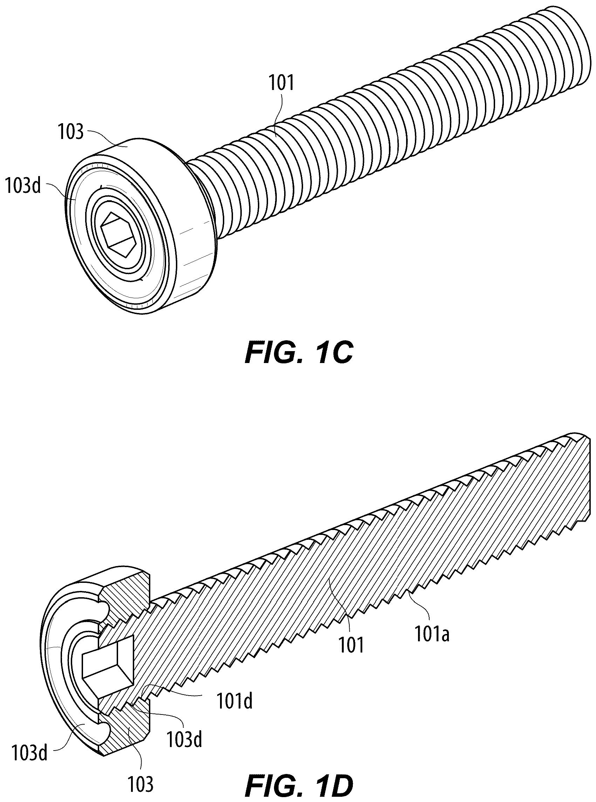

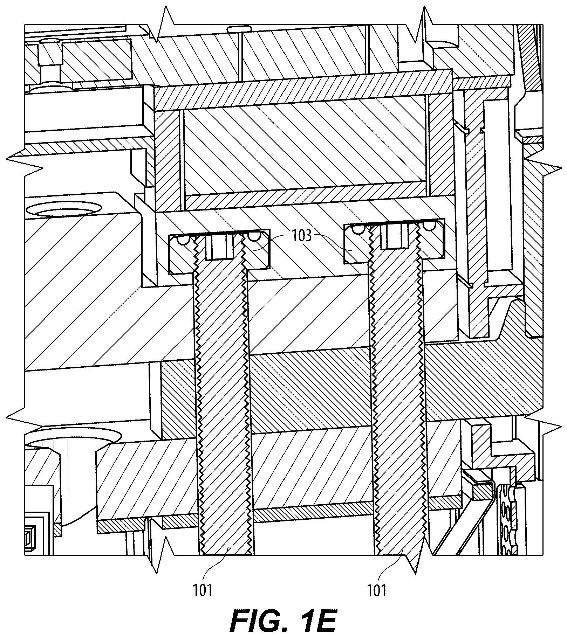

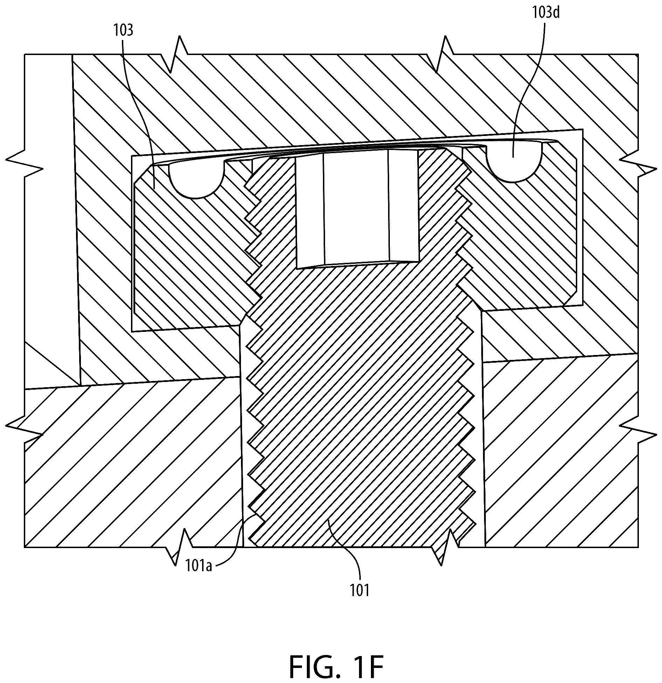

Reference will now be made to the drawings wherein like reference numerals identify similar structural features or aspects of the subject disclosure. For purposes of explanation and illustration, and not limitation, an illustrative view of an embodiment of a fastener in accordance with the disclosure is shown in Fig. 1A and is designated generally by reference character 100. Other views, embodiments, and/or aspects of this disclosure are illustrated in Figs. 1B-4D.

In accordance with at least one aspect of this disclosure, referring to Figs. 1A-1F, a fastener 100 can include a shaft 101 comprising a first material. The fastener 100 can include a head 103 attached to the shaft 101 comprising a second material. The second material can be more electrically conductive and/or thermally conductive than the first material. In this regard, the head 103 can conduct heat and/or conduct electricity better than the shaft 101, for example.

In certain embodiments, the head 103 extends radially outward of the shaft 101 (e.g., a flange head as shown). The head 103 can include any suitable shape (e.g., a smooth external cylinder shape with a hole in the middle as shown, e.g., a substantially toroidal shape). In certain embodiments, the shaft 101 includes first threads 101a for threading into one or more receiver openings (e.g., a nut or other threaded opening) having mating threads.

In certain embodiments, the head 103 includes reverse head threads 103b configured to mate with reverse shaft threads 101b to allow the head 103 to be reverse threaded to the shaft 101 relative to the first threads 101a. In certain embodiments, the head 103 includes an inner opening 103a defined therethrough having the reverse head threads 103b. The head 103 can be configured to receive the reverse shaft threads 101b in the inner opening 103a. In certain embodiments, a top surface 101c of the shaft 101 is accessible from a top of the fastener. The top surface 101c of the shaft 101 can include a tool interface 101d defined therein.

In certain embodiments, the head 103 can include a trough 103d defined in a top surface 103c thereof configured to receive a conductive spring element 105. The trough 103d can be annular and configured to receive an annular conductive spring element 105 (e.g., as shown in Figs. 1A and 1B). In certain embodiments, the fastener 100 can include the conductive spring element 105 (e.g., a steel annular spring configured to seat into the trough and to be compressed in an axial direction of the shaft).

In certain embodiments, the first material is steel (e.g., or other suitable conductive high strength material) and the second material is copper or brass (or other suitable higher conductivity material relative to the first material). Any other suitable first material and second material such that the second material has higher electrical and/or thermal conductivity is contemplated herein.

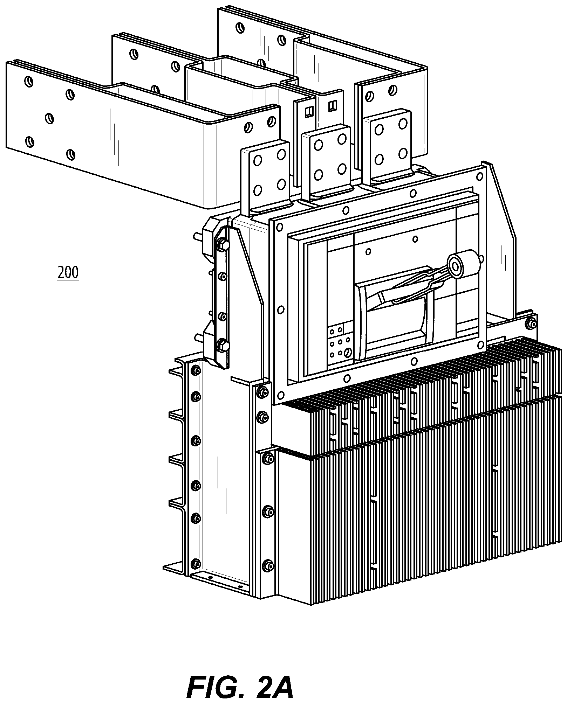

In accordance with at least one aspect of this disclosure, referring additionally to Figs. 2A-4D, an electrical assembly 200 can include a plurality of electrically conductive layers (e.g., as disclosed herein and/or any other suitable layers and/or arrangements thereof). The assembly 200 can include a fastener holding the plurality of electrically conductive layers (e.g., any suitable embodiment of a fastener 100 as disclosed herein), and a thermal interface module 204 in thermal communication with the head 103 of the fastener 100 for drawing heat away from the fastener 100. Any suitable total number of fasteners (e.g., one or more, for example, four as shown) for the assembly is contemplated herein.

In certain embodiments, the plurality of electrically conductive layers can include a first lug 201 configured to connect to one or more first cables (not shown), a second lug 203 configured to connect to one or more second cables (not shown), and a circuit breaker terminal 205 sandwiched between the first lug 201 and the second lug 203. In certain embodiments, the fastener 100 cab be threaded to a receiver opening 207 (e.g., a nut) to compress the plurality of electrically conductive layers.

The thermal interface module 204 can include a terminal interface layer 209 (e.g., made of silver coated copper or other suitable material) disposed on the first lug 201 and comprising an opening 209a, b, c, d configured to receive the head 103 of the fastener 100 (e.g., each opening configured to surround the head 103 of a fastener 100). The terminal interface layer 209 can include a plurality of openings 209a, b, c, d (e.g., four as shown), each configured such that the head 103 of each fastener 100 sits recessed in each opening 209a, b, c, d.

The assembly 200 can include a conductive spring element 105 (e.g., as disclosed herein) disposed in a trough 103d of the head 103 (e.g., as disclosed herein). The conductive spring element 105 can be configured to extend beyond a top surface 209e of the terminal interface layer 209, for example (e.g., and a top surface 103c of the head 103 does not extend to or beyond the top surface 209e of the terminal interface layer 209).

In certain embodiments, the thermal interface module 204 can include a cap layer 211 disposed over the head 103 of the fastener 100 to be in electrical communication with the spring element 105 extending from the head 103 (e.g., and/or to compress the conductive spring element 105, e.g., when fastened to the terminal interface layer 209 and/or the first lug 201).

In certain embodiments, the thermal interface module 204 can include a core 213 (e.g., copper coated with epoxy to be thermally conductive and electrically insulated), a core cover 215 (e.g., made of non-conductive material, e.g., plastic). In certain embodiments, the thermal interface module 204 further includes an electrically isolated, thermally conducting heat sink 217 configured to receive heat from the fastener 100 and conduct heat to an atmosphere. The heat sink 217 can be in thermal communication with the core 213 (e.g., via a core cap layer 221, e.g., made of copper or brass). The thermal interface module 204 and/or any suitable portion thereof can be fastened together and to any other suitable component(s) of the assembly 200 in any suitable manner (e.g., as shown). For example, one or more heads 103 of the fasteners 100 can trap the terminal interface layer 209 to the first lug 201.

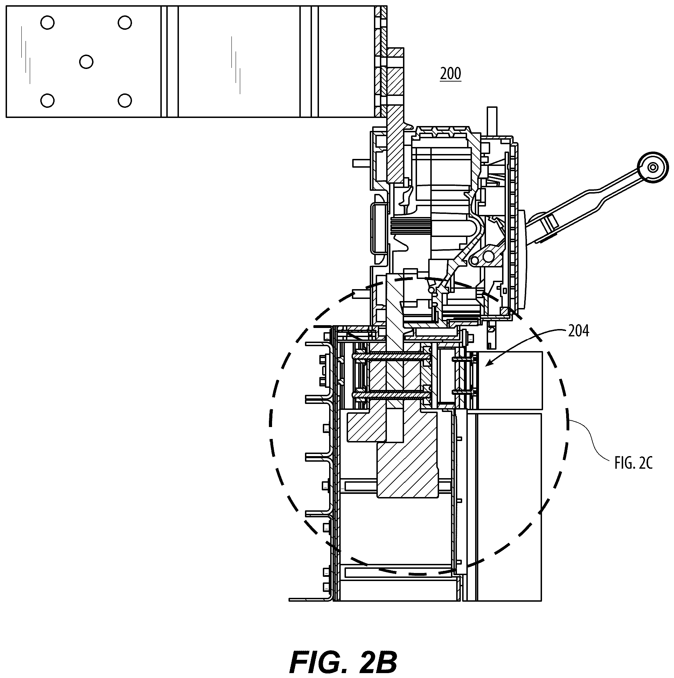

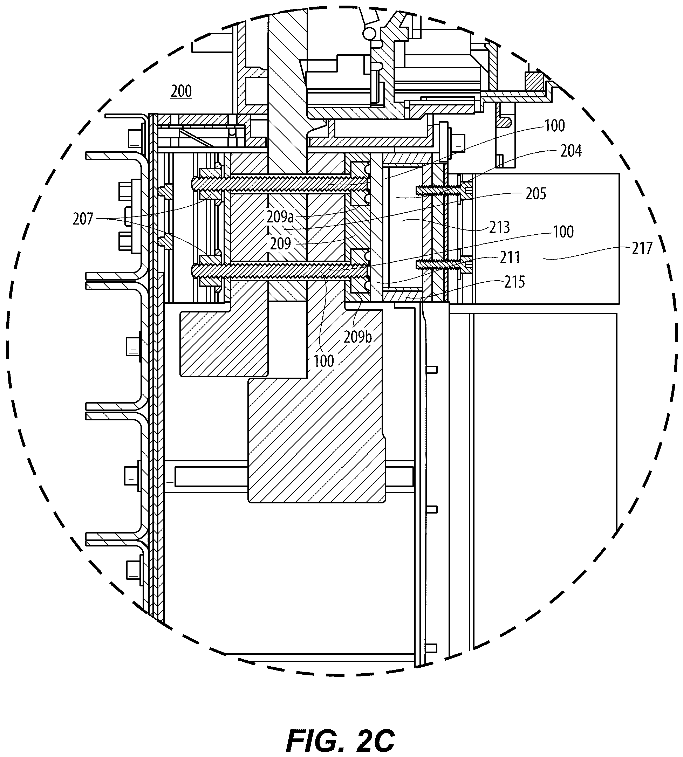

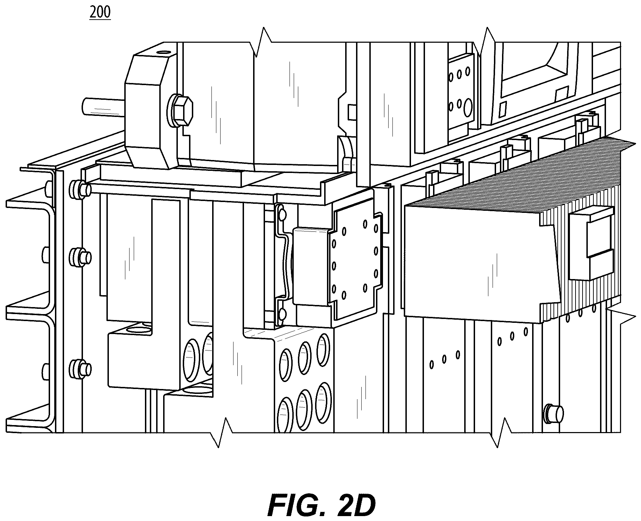

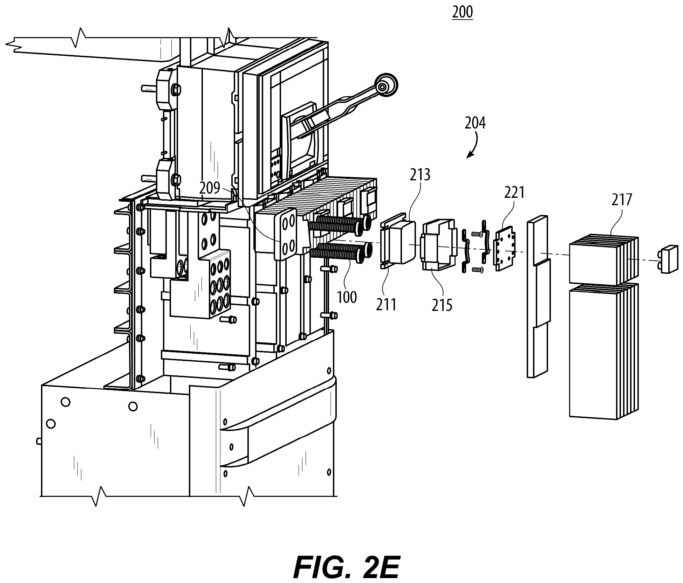

Fig. 2A is a perspective view of an embodiment of an electrical assembly in accordance with this disclosure. Fig. 2B is a cross-sectional view of the embodiment of Fig. 2A, shown having a plurality of the fastener of Fig. 1A. Fig. 2C is a close-up view of the embodiment of Fig. 2B. Fig. 2D is a perspective view of a portion of the embodiment of Fig 2A. Fig. 2E is an exploded view of the portion shown in Fig. 2D.

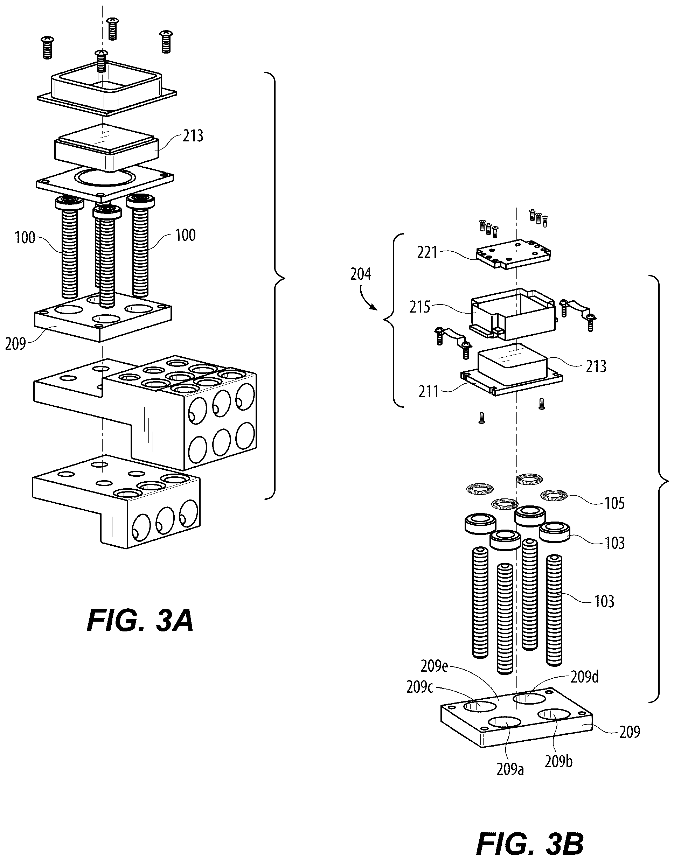

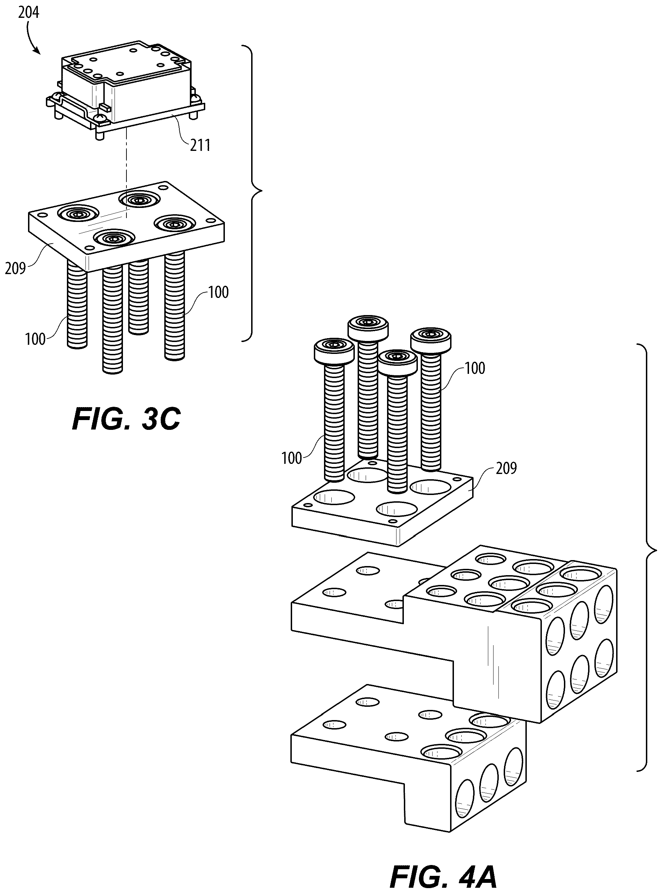

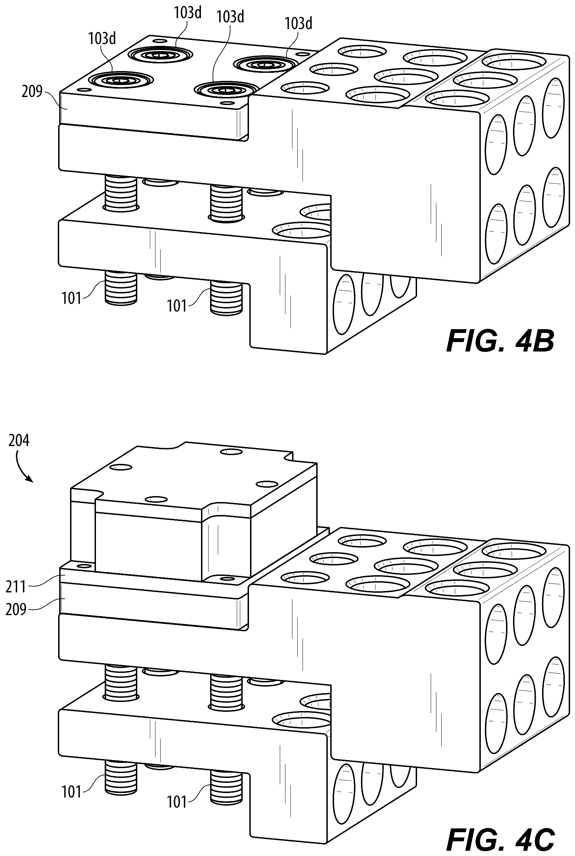

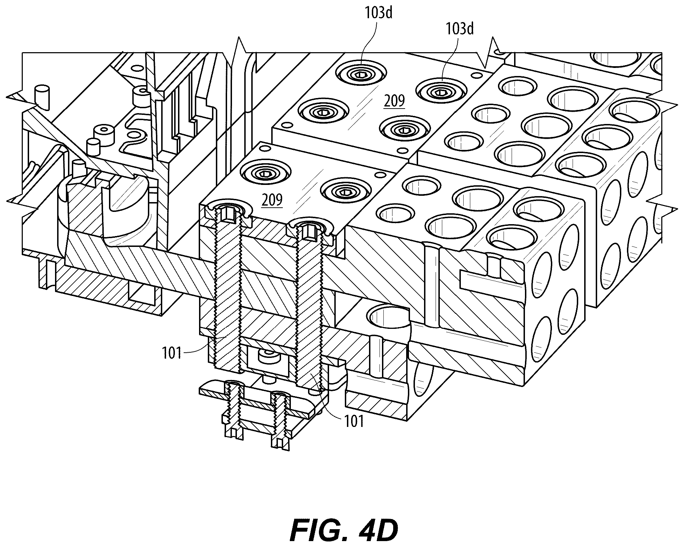

Fig. 3A is an exploded view of a portion of the embodiment of an assembly of Fig. 2A. Fig. 3B is another exploded view of the portion of Fig. 3A, shown without a first lug and second lug. Fig. 3C is a partially assembled view of the portion of Fig. 3B. Fig. 4A illustrates an exploded view of a portion of the assembly of Fig. 2A. Fig. 4B illustrates an assembled view of the portion of Fig. 4A. Fig. 4C illustrates an assembled view of the portion of Fig. 4B, showing an assembled thermal interface module. Fig. 4D illustrates an assembled view of the portion of Fig. 4B, shown installed in the assembly of Fig. 2A without a completed thermal interface module.

In certain embodiments, a screw can include one or more springs seated into a trough on a copper or brass head of a fastener and are sized to extend a bit out of a hole so that each spring can be compressed by a plate that sits on top thereof. The spring can be a low resistance electrically conductive spring element. Such a spring member can be configured to increase the amount of cross-sectional current flow area. Copper or brass for the fastener head can allow improved transmission of current straight through the head. Copper or brass can be significant higher performing than steel significantly in conduction. Copper and/or brass also dissipate heat much better than steel. Embodiments can include a two piece screw including a copper head and a steel stud. In certain embodiments, the head can be reverse screwed into the stud so it doesn't spin off.

Embodiments can provide the dual function of a high-strength mechanical securement means (in this case for a power connector) and provide an optimized, separable, thermal connection between the secured element and a thermal transfer element (in this case an isolator module discussed in another patent). Embodiments can utilize a combination of two different materials the first being mechanically robust (e.g., steel) to generate and carry the required clamping loads and the second being thermally conductive but less mechanically robust (e.g., copper) to simultaneous optimize mechanical strength and heat transfer. In addition, the use of special assembly techniques can be used to insure that, once assembled, the assembly emulates closely the behavior of a typical, e.g., threaded, fastener so that no special considerations are needed for installation or use.

In the field of electrical connections and, by extension, thermal transfer, the effectiveness and efficiency of elements and joints can be enhanced by both the inherent conductivity of the materials used and by minimizing the interface resistance between components, arranged serially, in the current or heat flow paths. To this end, the use of conventional steel fasteners provides well established benefits in creating the high clamping loads commensurate with good thermal transfer but with an inherently inferior thermal conductivity of steel. Conversely, copper is a material with excellent thermal transport properties but is lacking in mechanical strength so some arrangement that could benefit from both would be ideal. Further, in this embodiment, the arrangement of this assembly is applied in parallel with the main thermal transport path and, to do this, an additional feature of tolerance compliance is needed as well.

Embodiments can create a system that emulates the mechanical strength of a steel fastener and uses strategically placed (lower stress, high impact on thermal conductivity) copper to take advantage of the low joint resistance that radiates cylindrically from the center of the fastener. In addition, e.g., to work in parallel with the main body of the thermal transport system, certain embodiments can incorporate an elastic thermal interface material (e.g., a canted spring or joint compound) so that practical tolerance variations can be accommodated. Embodiments can utilize reverse threading to assembly a multi piece screw so that it will naturally be self-tightening against the normal assembly frictions and directions.

Those having ordinary skill in the art understand that any numerical values disclosed herein can be exact values or can be values within a range. Further, any terms of approximation (e.g., "about", "approximately", "around") used in this disclosure can mean the stated value within a range. For example, in certain embodiments, the range can be within (plus or minus) 20%, or within 10%, or within 5%, or within 2%, or within any other suitable percentage or number as appreciated by those having ordinary skill in the art (e.g., for known tolerance limits or error ranges).

The articles "a", "an", and "the" as used herein and in the appended claims are used herein to refer to one or to more than one (i.e., to at least one) of the grammatical object of the article unless the context clearly indicates otherwise. By way of example, "an element" means one element or more than one element.

The phrase "and/or," as used herein in the specification and in the claims, should be understood to mean "either or both" of the elements so conjoined, i.e., elements that are conjunctively present in some cases and disjunctively present in other cases. Multiple elements listed with "and/or" should be construed in the same fashion, i.e., "one or more" of the elements so conjoined. Other elements may optionally be present other than the elements specifically identified by the "and/or" clause, whether related or unrelated to those elements specifically identified. Thus, as a non-limiting example, a reference to "A and/or B", when used in conjunction with open-ended language such as "comprising" can refer, in one embodiment, to A only (optionally including elements other than B); in another embodiment, to B only (optionally including elements other than A); in yet another embodiment, to both A and B (optionally including other elements); etc.

As used herein in the specification and in the claims, "or" should be understood to have the same meaning as "and/or" as defined above. For example, when separating items in a list, "or" or "and/or" shall be interpreted as being inclusive, i.e., the inclusion of at least one, but also including more than one, of a number or list of elements, and, optionally, additional unlisted items. Only terms clearly indicated to the contrary, such as "only one of" or "exactly one of," or, when used in the claims, "consisting of," will refer to the inclusion of exactly one element of a number or list of elements. In general, the term "or" as used herein shall only be interpreted as indicating exclusive alternatives (i.e., "one or the other but not both") when preceded by terms of exclusivity, such as "either," "one of," "only one of," or "exactly one of."

Any suitable combination(s) of any disclosed embodiments and/or any suitable portion(s) thereof are contemplated herein as appreciated by those having ordinary skill in the art in view of this disclosure.

The embodiments of this disclosure, as described above and shown in the drawings, provide for improvement in the art to which they pertain. While the subject disclosure includes reference to certain embodiments, those skilled in the art will readily appreciate that changes and/or modifications may be made thereto without departing from the spirit and scope of the subject disclosure.

## Claims

1. A fastener, comprising:
a shaft comprising a first material; and
a head attached to the shaft comprising a second material, wherein the second material is more electrically conductive and/or thermally conductive than the first material, wherein the head in particular extends radially outward of the shaft.

2. The fastener of claim 1, wherein the shaft includes first threads for threading into one or more receiver openings having mating threads, and wherein the head includes reverse head threads configured to mate with reverse shaft threads to allow the head to be reverse threaded to the shaft relative to the first threads.

3. The fastener of claim 2, wherein the head includes an inner opening defined therethrough having the reverse head threads, wherein the head is configured to receive the reverse shaft threads in the inner opening.

4. The fastener of any one of the preceding claims, wherein a top surface of the shaft is accessible from a top of the fastener, and wherein the top surface of the shaft includes a tool interface defined therein, and/or wherein the head includes a trough defined in a top surface thereof configured to receive a conductive spring element.

5. The fastener of claim 4, wherein the trough is annular and configured to receive an annular conductive spring element, in particular further comprising the conductive spring element.

6. The fastener of any one of the preceding claims, wherein the first material is steel and the second material is copper or brass.

7. An electrical assembly, comprising:
a plurality of electrically conductive layers;
a fastener holding the plurality of electrically conductive layers, the fastener comprising:
a shaft comprising a first material; and
a head attached to the shaft comprising a second material, wherein the second material is more electrically conductive and/or thermally conductive than the first material; and
a thermal interface module in thermal communication with the head for drawing heat away from the fastener.

8. The assembly of claim 7, wherein the plurality of electrically conductive layers include:
a first lug configured to connect to one or more first cables;
a second lug configured to connect to one or more second cables; and
a circuit breaker terminal sandwiched between the first lug and the second lug.

9. The assembly of claim 7 or 8, wherein the fastener is threaded to a receiver opening to compress the plurality of electrically conductive layers.

10. The assembly of claim 8 or 9, wherein the thermal interface module includes a terminal interface layer disposed on the first lug and comprising an opening configured to receive the head of the fastener.

11. The assembly of claim 10, wherein the head includes a trough defined in a top surface of the head and configured to receive a conductive spring element, wherein the assembly further comprises the conductive spring element disposed in the trough and configured to extend beyond a top surface of the terminal interface layer.

12. The assembly of claim 11, wherein the thermal interface module includes a cap layer disposed over the head of the fastener to be in electrical communication with the spring element extending from the head.

13. The assembly of any one of the preceding claims 7 - 12, wherein the head includes reverse head threads configured to mate with reverse shaft threads to allow the head to be reverse threaded to the shaft relative to first threads.

14. The assembly of claim 13, wherein the head includes an inner opening defined therethrough having the reverse head threads, wherein the head is configured to receive the reverse shaft threads in the inner opening, wherein in particular the first material is steel and the second material is copper or brass.

15. The assembly of any one of the preceding claims 7 - 14, wherein the thermal interface module further includes an electrically isolated, thermally conducting heat sink configured to receive heat from the fastener and conduct heat to an atmosphere.
